# DEMANDE DE BREVET EUROPEEN

(11) **EP 2 068 358 A1**
(43) Date de publication de la demande: **10.06.2009**
(21) Numéro de dépôt: 08169798.9
(22) Date de dépôt: 24.11.2008
(51) Int. Cl.: H01L 21/762, H01F 10/24, C30B 33/06, H01F 41/34

(54) **Procédé de transfert de films**

(30) Priorité: 28.11.2007 FR 0759389
(71) Demandeur: COMMISSARIAT A L'ENERGIE ATOMIQUE, 75015 Paris (FR)
(72) Inventeur: Moriceau, Hubert, 38120, SAINT EGREVE (FR); Couchaud, Maurice, 38160, IZERON (FR); Deschanvres, Jean-Luc, 38240, MEYLAN (FR); Joudrier, Anne-Laure, 77240, VERT-SAINT-DENIS (FR)
(74) Mandataire: Ilgart, Jean-Christophe

(57) **Abrégé**

L'invention concerne un procédé de report d'une couche en un premier matériau, à partir d'un premier substrat (4), présentant des défauts dans une zone proche de sa surface, sur un substrat hôte (20), en un deuxième matériau, comportant :
a) une étape d'amincissement du premier substrat, pour former un premier substrat aminci (24),
b) une implantation d'ions ou d'atomes dans ce premier substrat, pour y former un plan d'implantation (6), délimitant la couche à reporter,
c) un report de ladite couche sur le substrat hôte (20), par fracture du substrat le long du plan d'implantation.

## Description

### DOMAINE TECHNIQUE ET ART ANTERIEUR

L'invention concerne un procédé pour transférer des films à partir de substrats.

Certains matériaux peuvent être obtenus par des techniques de croissance cristalline telle que l'épitaxie en phase liquide sur un substrat.

C'est notamment le cas pour réaliser des films de grenats magnétiques de haute qualité cristalline sur des substrats de grenat (GGG, NdGG, SGGG...). Le GGG désigne un matériau de composition Gd₃Ga₅O₁₂; le NdGG un matériau de composition Nd₃Ga₅O₁₂ ; le SGGG un grenat de gallate de Gadolinium substitué, par exemple de composition Gd₃₋ₓ Caₓ Ga_{5-y-z}, Mg_{y} Zr_{z} O₁₂.

La technique d'épitaxie en phase liquide permet la réalisation de films épais, ou substrats, de l'ordre d'un micromètre à plusieurs micromètres voire plusieurs dizaines de micromètres, par exemple des films de grenats magnétiques contenant du bismuth et caractérisés par un fort effet de rotation Faraday.

Mais, par cette technique d'épitaxie, les vitesses de croissance sont assez rapides.

La réalisation d'un substrat d'épaisseur de l'ordre de quelques dixièmes de micromètres est donc très délicate car elle suppose une durée d'épitaxie très courte. Ceci nécessite d'intégrer dans cette durée les temps de sortie du bain d'épitaxie. En outre, la composition de la partie du substrat épitaxié, réalisée pendant le temps de sortie, n'est pas homogène avec le reste du substrat déjà élaboré.

Il y a donc un fort risque de non homogénéité de composition d'un tel substrat voire de défaillance de la partie superficielle du film épitaxié. Le même problème se pose pour d'autres techniques de dépôt, par exemple le dépôt par ablation laser d'une cible dont la composition va évoluer, au fur et à mesure de l'ablation, entraînant une évolution corrélative du dépôt.

### EXPOSÉ DE L'INVENTION

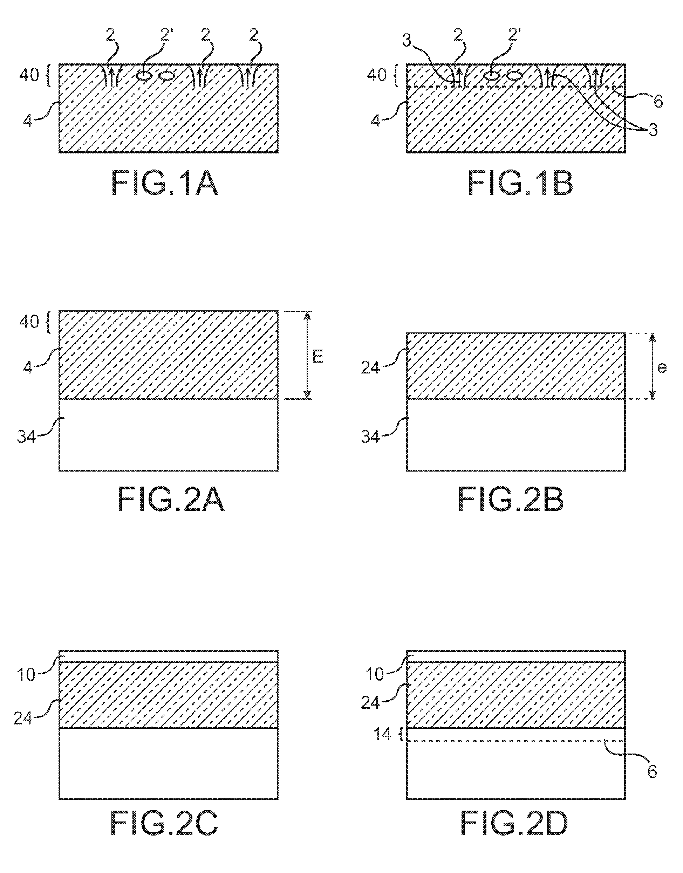

Outre le problème mentionné ci-dessus, les inventeurs ont mis en évidence que, avec la technique connue d'épitaxie en phase liquide, on obtient une structure telle qu'illustrée en figure 1A, avec certains défauts cristallins 2, de type " traversant ", présents surtout dans la partie superficielle 40 de la couche épitaxiée 4. Des défauts non traversant 2' sont également représentés, surtout présents dans la partie superficielle de la couche épitaxiée.

Ces défauts sont d'autant plus gros et denses qu'on s'approche de la surface libre 4' du film. Ces défauts empêchent toute utilisation de la partie superficielle 40 de la couche, et notamment tout transfert de film à partir de cette partie superficielle, sur un quelconque substrat.

En outre, comme illustré en figure 1B par les flèches 3, ces défauts peuvent par exemple servir de canaux d'exodiffusion pour des espèces gazeuses qui seraient implantées, par exemple par implantation ionique, dans le substrat à une profondeur 5, fonction de l'énergie d'implantation, relativement proche de la surface 4'. Un film correspondant à une portion superficielle 40 du substrat ne peut donc pas, non plus, être transféré, en particulier de façon homogène, sur un substrat hôte à partir d'une technique d'implantation, pour former un plan 6 de fragilisation par implantation d'ions ou d'atomes, puis par collage et report sur ce substrat hôte.

Le même type de problème se pose pour une couche 4 en un autre type de matériau, élaborée par épitaxie ou par toute autre technique connue, ce matériau présentant des défauts 2 tels que des défauts cristallins ou des défauts d'homogénéité de composition ou autres dans sa partie superficielle 40', qui ne peut être utilisée, en particulier pour un report sur un substrat receveur.

Selon l'invention, on élimine la partie superficielle d'une couche, présentant ou susceptible de présenter des défauts, et on réalise un transfert de la partie non éliminée de cette couche, initialement enfouie, et une partie d'un substrat de dépôt, sur un substrat receveur. La partie initialement enfouie de la couche est de composition homogène et présente pas ou peu de défauts, ou moins que la partie superficielle éliminée.

L'invention concerne donc un procédé de formation d'une couche sur un substrat hôte, comportant :
a) une étape de dépôt d'une couche, de préférence monocristalline, sur un substrat de dépôt,
b) une étape d'amincissement de cette couche, pour former une couche amincie,
c) une implantation d'ions ou d'atomes dans le substrat de dépôt, pour y former une zone d'implantation,
d) un report de ladite couche amincie et du substrat de dépôt, sur le substrat hôte, par exemple en verre, ou en grenat, ou en saphir, ou en diamant, ou en céramique ; le report peut être réalisé par collage direct ou moléculaire,
e) une fracture du substrat de dépôt, le long de la zone d'implantation, sensiblement le long d'un plan moyen de cette zone.

Le matériau de la couche déposée est par exemple du grenat, notamment du grenat magnétique ou du grenat ferrimagnétique dopé au bismuth. Le substrat de dépôt peut être en grenat, par exemple GGG, ou NdGG, ou SGGG.

La couche déposée est par exemple une couche monocristalline épitaxiée sur un substrat de dépôt monocristallin.

La technique de dépôt peut être l'épitaxie en phase liquide, mais d'autres techniques de dépôt de cette couche sont concernées, telles que le dépôt par ablation laser d'une cible, ou par pulvérisation cathodique, ou par faisceau d'ions.

L'étape b) permet d'éliminer une portion superficielle de la couche déposée, qui comporte des défauts superficiels et/ou des non homogénéités de composition, proches de sa surface. Parmi ces défauts on citera un enrichissement de la composition en éléments d'un solvant, une variation relative des éléments d'un soluté, l'augmentation de la taille et/ou de la densité des défauts cristallins (par exemple dislocations traversantes ou non, fautes d'empilement, inclusions, précipités...).

L'étape b) est réalisée pour éliminer une épaisseur de couche d'au moins 500 nm. On rappelle que les étapes usuelles d'e polissage et/ou d'activation connus réalisent au mieux une consommation de matière de 30 nm à 50 nm, en tout cas inférieure à 150 nm.

La partie initiale du dépôt étant elle même partiellement défectueuse ou non homogène, on réalise une zone de fragilisation, non pas dans la couche déposée, mais dans le substrat de dépôt sous jacent. Le film reporté sur le substrat hôte comprend alors une partie du substrat sur lequel le dépôt est réalisé.

La couche déposée initialement peut avoir une épaisseur initiale supérieure à 1 µm. Au cours de l'étape b), on grave ou on amincit cette couche pour n'en laisser qu'une épaisseur, de préférence inférieure à 1 µm, ou même à 500 nm.

Eventuellement, on dépose, sur la couche obtenue après amincissement ou gravure, une ou plusieurs couches intermédiaires, composées ou non du même matériau, telles qu'une ou plusieurs couches de protection et/ou d'aide au collage direct, par exemple une couche d'oxyde de silicium et/ou de nitrure de silicium et/ou d'oxyde d'aluminium....

La zone d'implantation ionique et/ou atomique peut être réalisées dans le substrat de dépôt, avant ou après formation d'une ou plusieurs couches intermédiaires. Par exemple, on implante une ou plusieurs espèces gazeuses telles que de l'hydrogène et/ou de l'hélium. Cette étape permet de réaliser une zone ou un plan de fragilisation dans le substrat de dépôt, à une certaine profondeur.

Les surfaces de la couche amincie, à reporter et du substrat hôte, peuvent être préparées, avant l'étape d), en vue d'un assemblage.

On obtient alors une structure comportant au moins le substrat hôte, la partie amincie de la couche déposée, éventuellement avec au moins une couche intermédiaire entre substrat hôte et partie amincie, et une portion de substrat de dépôt. Cette dernière peut être éliminée.

Si la surface, ou une portion superficielle, de la couche initiale déposée, comportait, avant amincissement, une certaine densité, ou première densité, de défauts d'une certaine taille moyenne, la couche amincie reportée ne comporte pas ces défauts, ou comporte des défauts à une deuxième densité, inférieure à la première densité, et/ou des défauts de taille moindre.

Le substrat hôte peut comporter une ou des fonctionnalités, par exemple un ou plusieurs composants optiques, et/ou au moins une couche en matériau semi-conducteur III - V, ou en verre ayant subi une variation de concentration d'ions, et/ou un ou plusieurs guides d'ondes.

### BRÈVE DESCRIPTION DES DESSINS

- Les figures 1A et 1B représentent un procédé de l'art antérieur,
- les figures 2A à 2F représentent des étapes d'un procédé selon l'invention,
- la figure 3 représente une technique de dépôt par ablation laser.

### EXPOSÉ DÉTAILLÉ DE MODES DE RÉALISATION PARTICULIERS

Un premier exemple de réalisation de l'invention est donné en liaison avec les figures 2A-2F.

Il est d'abord procédé à une croissance épitaxiale d'une couche 4 sur un substrat de croissance 34(figure 2A). Par exemple on réalise une couche 4 de grenat ferrimagnétique dopée au bismuth (par exemple de composition Bi_{0,8} Tm_{0,25}Gd_{1,45}Pr_{y0,35}) (Ga_{0,7} Fe_{4,3})O₁₂) et épitaxiée sur un substrat 34 de grenat de gallate de gadolinium non magnétique substitué (SGGG). Le substrat est substitué pour présenter un paramètre de maille proche de celui des films à réaliser.

Les compositions chimiques du grenat, du SGGG, du GGG sont celles déjà indiquées dans l'introduction.

La couche 4 obtenue peut avoir une épaisseur E par exemple de l'ordre de 1 µm ou plus, par exemple 2 µm ou 5 µm. Les défauts du type 2, 2' (figure 1A) ne sont pas représentés sur cette figure, mais sont présents ou peuvent être présents, surtout dans une portion 40 superficielle. On réalise donc un amincissement de la couche 4, par exemple par polissage mécano-chimique et/ou attaque chimique. On élimine donc la portion 40 superficielle du substrat.

L'épaisseur e de la couche 24 amincie obtenue (figure 2B) est alors plus faible que l'épaisseur initiale, elle est par exemple inférieure à 1 µm, de l'ordre de quelques centaines de nm, par exemple encore inférieure à 500 nm, par exemple 300nm.

Un dépôt d'une ou plusieurs couches intermédiaire 10 (par exemple un dépôt d'oxyde de silicium et/ou de nitrure de silicium) peut ensuite être réalisé (figure 2C) La ou les diverses couches intermédiaires peut avoir différentes fonctions. Cette couche ou certaines de ces couches vont servir en protection, par exemple pour limiter l'exodiffusion d'espèces qui seront implantées ultérieurement (c'est par exemple le cas d'une couche 10 en SiN), alors que la couche ou d'autres couches (par exemple une couche 10 en SiO₂) vont faciliter le collage direct ultérieur.

On procède ensuite (figure 2D) à une implantation atomique et/ou ionique, pour former une zone ou un plan de fragilisation 6 dans le substrat 34 de croissance. Cette zone de fragilisation permettra ultérieurement de séparer, du reste du substrat 34, une mince couche 14 qui porte la couche 24 et, éventuellement, une ou des couches intermédiaires 10, qui a, ou qui ont, une ou plusieurs des fonctions indiquées ci-dessus .

En variante, on peut inverser l'ordre des étapes d'implantation dans le substrat 34 de croissance et de dépôt des couches intermédiaires 10 : on implante dans le substrat 34 avant de réaliser la ou les couches 10.

La profondeur d'implantation dans le substrat 34 dépend surtout de l'énergie d'implantation. Cette profondeur peut par exemple être préalablement déterminée par le logiciel de simulation SRIM, voir par exemple à ce sujet l'ouvrage "The Stopping and Range of Ions in Solids", by J. F. Ziegler, J. P. Biersack and U. Littmark, Pergamon Press, New York, 1985 et la contribution de J. F. Ziegler dans www.SRIM.org.

Quant aux doses d'implantation, elles seront par exemple comprises dans une gamme allant de 1.10¹⁶ cm⁻² à 4.10¹⁷ cm⁻².

Par exemple, pour une implantation d'hélium seul, la dose d'implantation est préférentiellement comprise entre 5.10¹⁶ cm⁻² et 2.10¹⁷ cm⁻². Elle est avantageusement égale à, ou de l'ordre de, 7.10¹⁶ cm⁻².

Pour une implantation d'hydrogène seul, elle est préférentiellement comprise entre 5.10¹⁶ cm⁻² et 3.10¹⁷ cm⁻² et avantageusement entre 7.10¹⁶ cm⁻² et 1,5.10¹⁷ cm⁻².

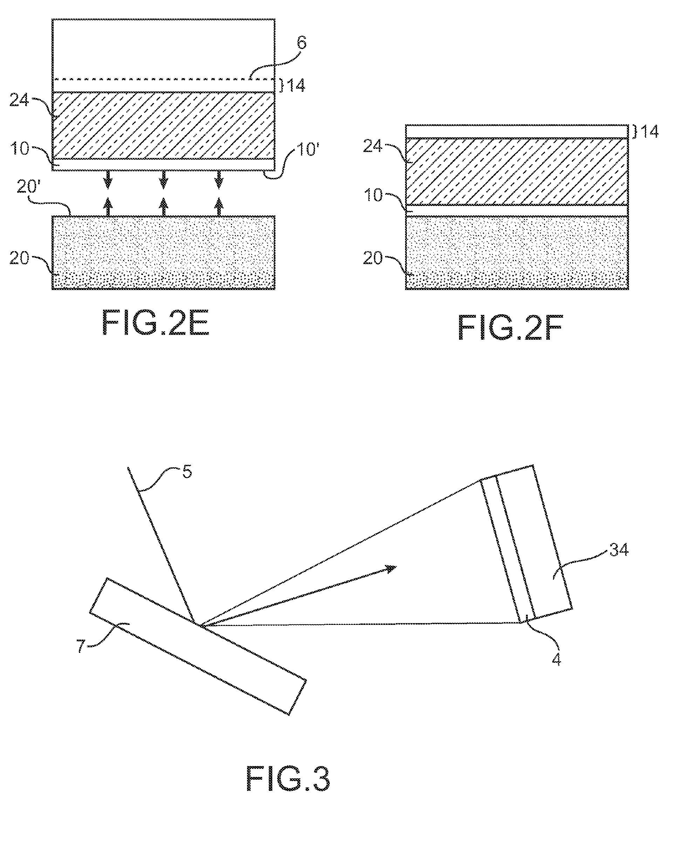

La surface 20' d'un substrat hôte 20 peut ensuite être préparée, par nettoyage chimique (figure 2E). Il en va de même pour la surface de la couche 24, éventuellement de la surface libre 10' de la couche 10 la plus extérieure. La surface 20' peut être munie elle aussi d'une couche (non représentée sur la figure 2E) d'aide au collage.

Le substrat hôte 20 a de préférence un coefficient de dilatation thermique égal à, ou relativement proche de, celui de la couche 24 à reporter (ou du substrat 34). Le substrat hôte 20 peut être par exemple en verre, avec un coefficient de dilatation thermique supérieur à 2 10⁻⁶ /K, par exemple 5 10⁻⁶ /K, ou (dans le cas où la couche à reporter 24 est en grenat) en un autre grenat, ou en saphir, ou en diamant, ou en une céramique par exemple d'alumine.... Le substrat hôte peut être couvert d'une couche de collage, par exemple une couche déposée de SiO₂. Ces matériaux conviennent particulièrement bien dans le cas d'un report d'une couche 24 à partir d'un substrat de croissance 34 en grenat.

Le substrat hôte peut contenir une couche (par exemple en matériau semi-conducteur III - V, ou en verre ayant subi une variation de concentration d'ions), pouvant supporter un composé, par exemple pour des applications d'optique intégrée. Encore à titre d'exemple, le substrat hôte peut contenir des guides d'ondes.

La couche 24 est ensuite reportée sur le substrat hôte (figure 2E), par sa face libre ou par la face libre de la couche 10, via un collage direct, ou moléculaire.

Il peut ensuite être procédé à la fracture le long du plan 6 de fragilisation, par exemple par traitement thermique dans une gamme de 300°C à 600° et avantageusement dans une gamme de 400° à 500°, et ce pendant une durée en général de quelques minutes à quelques heures, fonction, notamment, de la température du traitement thermique. C'est par exemple une durée de 5 h à 490°C pour une implantation d'hélium.

Cette fracture est par exemple du type de celle réalisée dans le procédé Smart Cut^{™}. Ce procédé est décrit dans l'article de B. Aspar et A.J. Auberton - Hervé dans « Silicon Wafer Bonding Technology for VLSI and MEMS applications », edited by S.S. Iyer and A.J. Auberton-Hervé, 2002, INSPEC, London, Chapter 3, pages 35-52.

Cette fracture va permettre de reporter la couche 24, qui peut elle même être partiellement défectueuse ou non homogène (mais moins que la partie superficielle 40 qui a été éliminée), en évitant des risques tels que ceux décrits ci-dessus en liaison avec les figures 1A et 1B, notamment le risque d'exodiffusion d'espèces implantées.

La structure obtenue, illustrée en figure 2F, comporte, outre le substrat 20 de report, une ou plusieurs éventuelles(s) couche(s) 10 intermédiaires, par exemple de protection et/ ou d'assistance au collage direct, et le film ou la couche 24. Provenant d'une zone de la couche initiale 4 ne présentant pas ou peu de défauts tels que les défauts 2, la couche reportée 24 a moins de défauts et/ou des défauts de moindre taille que la portion superficielle 40 qui a été éliminée.

On enlève ensuite la couche 14 issue du substrat de croissance 34. Les interfaces peuvent être consolidées par des traitements thermiques.

Les deux exemples qui vont être donnés concernent le report d'une couche 24 de grenat sur un substrat 20 en verre.

Dans le premier exemple, il est d'abord procédé à l'épitaxie d'une couche 4 de grenat (figure 2A). L'épaisseur de la couche 4 ainsi épitaxiée est de l'ordre de E = 1,8 µm juste après épitaxie.

Après un polissage mécano-chimique et un amincissement chimique, pour retirer la partie la plus défectueuse ou la moins homogène du film, il reste une couche épitaxiale 24 d'épaisseur e environ 350 nm (figure 2B).

Deux dépôts 10 sont ensuite successivement réalisés, d'abord un dépôt de 50 nm de SiN, puis un dépôt de 200 nm de SiO₂, à 300°C.

L'implantation est une implantation d' hélium, à une dose de 7.10¹⁶ He⁺.cm⁻², avec une énergie de 200 keV (figure 2D). Ces conditions d'implantation permettent de réaliser une zone de fragilisation à une profondeur d'environ 200nm dans le substrat 34 initial d'épitaxie. Ici on utilise un substrat 34 de SGGG. Un polissage mécano-chimique de la couche 10 de SiO₂ est effectué, puis un nettoyage de surface de cette même couche polie. Il reste une épaisseur de 50 nm de SiO₂.

La surface 20' du substrat d'accueil, hôte, 20 est nettoyée. La surface de la couche superficielle de SiO₂ est assemblée par collage direct avec cette surface 20'.

Enfin, un traitement thermique, pendant 5 h, à 490°C permet de fracturer le substrat 34 (figure 2F).

L'épaisseur totale reportée sur le substrat hôte 20 est d'environ 640 nm. Elle correspond à l'assemblage suivant (figure 2F) :
couche 10 SiO₂/couche 10 SiN/couche 24 de grenat ferrimagnétique/couche 14 de SGGG,
puisque la zone fragilisée est dans le substrat de croissance 34.

Dans le deuxième exemple, il est d'abord procédé à l'épitaxie, sur un substrat 34 de SGGG, d'une couche 4 de grenat (figure 2A), d'épaisseur E = 1,8 µm après épitaxie.

Après un polissage mécano-chimique et un amincissement chimique, il reste une couche 4' d'épaisseur e égale à environ 300 nm.

Un dépôt 10 de 80 nm de SiO₂ est ensuite réalisé.

L'implantation est une implantation d'ions hydrogène, à une dose de 1.10¹⁷ H⁺.cm⁻², avec une énergie de 210 keV (figure 2C). Pour de telles conditions d'implantation, on provoque une zone de fragilisation à une profondeur d'environ 1 µm dans le substrat initial d'épitaxie 34. Suivant la nature de l'oxyde déposé et sa rugosité de surface, on prépare, par un procédé de CMP (polissage mécano-chimique), la surface de la couche 10 de SiO₂, puis on nettoie la surface de cette même couche polie pour la rendre apte à un collage direct ultérieur. Il reste une épaisseur de 50 nm de SiO₂.

Un nettoyage de cette même couche est réalisé.

La surface 20' du substrat d'accueil 20 est nettoyée. Sur cette surface la couche 10 de SiO₂ est assemblée par collage direct (figure 2E).

Enfin, un traitement thermique, pendant 4 h, à 450°C permet de fracturer le substrat 34 (figure 2E).

L'épaisseur totale reportée sur le substrat hôte 20 est d'environ 1,35 µm. Elle correspond à un assemblage couche 10 SiO₂/couche 24 de grenat magnétique/couche 14 de SGGG, puisque la zone fragilisée est dans le substrat de croissance 34.

L'invention s'applique plus généralement à tout transfert d'une partie enfouie d'une couche cristalline dont la partie superficielle a pu être "dégradée" pendant une opération de dépôt (par toute technique d'épitaxie ou par un autre procédé) et/ou pendant des opérations de traitement postérieures au dépôt. La dégradation peut se traduire par une partie finale de croissance de la couche présentant plus de défauts ou des défauts plus gros que dans la partie initiale du dépôt, et/ou par une modification de composition dans la partie superficielle, liée au mode de dépôt utilisé, et/ou par des inclusions et/ou des précipités dans cette partie superficielle de la couche.

Dans tous ces cas on retire ou on sacrifie alors la partie superficielle et on procède aux étapes décrites ci-dessus en liaison avec les figures 2C - 2F.

Parmi les techniques de dépôt autres que l'épitaxie en phase liquide, qui sont concernées par la présente invention, on peut citer l'ablation laser, la pulvérisation cathodique, par faisceau d'ions...etc. Ces techniques peuvent entraîner des non homogénéités de composition ou une augmentation de la défaillance, dans la partie la plus proche de la surface libre de la couche déposée, au cours du dépôt ou après celui-ci. Les couches déposées par ces techniques ne permettent donc pas le transfert direct sur un substrat de report et, selon la présente invention, on en retire la partie superficielle avant de procéder aux étapes décrites ci-dessus en liaison avec les figures 2C-2F.

Ainsi, la figure 3 représente la réalisation d'une couche 4 sur un substrat de dépôt 34, par ablation par faisceau laser 5 d'une cible 7. La composition de cette dernière va évoluer dans le temps, puisque l'action du faisceau 5 va y induire des effets tels qu'une fusion progressive du matériau de la cible ou d'autres effets. La cible 7, à partir de laquelle la couche 4 est constituée, évoluant, il en va de même de la composition de la couche 4. Là encore, l'invention permet de remédier à ce problème en éliminant une portion supérieure de la couche 4 et en reportant le reste 24 de cette couche et une partie du substrat 34, comme expliqué ci-dessus en liaison avec sur la figure 2F, après implantation ionique dans le substrat 34.

## Revendications

1. Procédé de formation d'une couche (24) sur un substrat hôte (20), comportant :
a) une étape de dépôt d'une couche (4) monocristalline, sur un substrat (34) de dépôt, pour former une couche déposée, comportant une partie superficielle présentant des défauts, tels que des défauts cristallins ou des défauts d'homogénéité de composition, et une partie enfouie, présentant moins de défauts que la partie superficielle,
b) une étape d'amincissement de cette couche, dont la partie superficielle est éliminée, laissant subsister la partie enfouie, formant une couche amincie (24),
c) une implantation d'ions ou d'atomes dans le substrat de dépôt, pour y former une zone (6) d'implantation,
d) un report de ladite couche amincie (24) et du substrat de dépôt (34), sur le substrat hôte (20),
e) une fracture du substrat de dépôt (34), le long de la zone d'implantation.

2. Procédé selon la revendication 1, comportant en outre, avant l'étape c) ou avant l'étape d), une étape de formation d'au moins une couche (10) intermédiaire.

3. Procédé selon la revendication 2, ladite couche intermédiaire étant une couche d'oxyde de silicium et/ou de nitrure de silicium et/ou d'oxyde d'aluminium.

4. Procédé selon l'une des revendications 1 à 3, l'implantation étant réalisée à une dose comprise entre 1.10¹⁶ cm⁻² et 4.10¹⁷ cm⁻².

5. Procédé selon l'une des revendications 1 à 4, le substrat hôte (20) étant en verre, ou en grenat, ou en saphir, ou en diamant, ou en céramique.

6. Procédé selon l'une des revendications 1 à 5, le substrat hôte (20) comportant en outre une couche d'aide au collage.

7. Procédé selon l'une des revendications 1 à 6, la couche (4) déposée ayant, avant l'étape b), une épaisseur supérieure à 1 µm, et la couche amincie (24) ayant, après l'étape b), une épaisseur inférieure à 1 µm.

8. Procédé selon l'une des revendications 1 à 7, l'étape a) comportant une croissance épitaxiale de la couche (4) sur le substrat (34) de dépôt.

9. Procédé selon l'une des revendications 1 à 8, l'étape a) comportant une épitaxie en phase liquide ou un dépôt par ablation laser d'une cible (7), ou par pulvérisation cathodique, ou par faisceau d'ions, pour former la couche déposée (4).

10. Procédé selon l'une des revendications 1 à 9, le matériau de la couche déposée étant du grenat.

11. Procédé selon l'une des revendications 1 à 10, le matériau de la couche déposée étant du grenat ferrimagnétique dopé au bismuth.

12. Procédé selon l'une des revendications 10 ou 11, le substrat de dépôt étant en grenat, par exemple GGG, ou NdGG, ou SGGG et/ou le substrat hôte (20) comportant une couche en matériau semi-conducteur III - V, ou en verre ayant subi une variation de concentration d'ions.

13. Procédé selon l'une des revendications 1 à 12, l'étape d) de report étant une étape de collage direct ou moléculaire.

14. Procédé selon l'une des revendications 1 à 13, le substrat hôte (20) comportant un ou plusieurs composants optiques et/ou comportant un ou plusieurs guides d'ondes.

15. Procédé selon l'une des revendications 1 à 14, l'étape b) permettant d'enlever au moins 500 nm de matériau de la couche monocristalline.
